# EUROPEAN PATENT APPLICATION

(11) **EP 4 550 309 A1**
(43) Date of publication of application: **07.05.2025**
(21) Application number: 24209397.9
(22) Date of filing: 29.10.2024
(51) Int. Cl.: G10K 15/02, B60Q 5/00

(54) **AUDIO PROCESSING PLUG-IN EFFECTS FOR VEHICLES AND ASSOCIATED USER INTERFACE**

(30) Priority: 31.10.2023 US 202363594505 P
(71) Applicant: Borla, David, Akiba, Thousand Oaks, CA 91362 (US)
(72) Inventor: Borla, David, Akiba, Thousand Oaks, CA 91362 (US)
(74) Representative: Berggren Oy

(57) **Abstract**

Various implementations include a system for producing vehicle sounds. The system includes speakers, a controller, a processor, and a system memory. The processor is in operative communication with an output source of a vehicle, the controller, and the speakers. The system memory is configured to store sound profiles. The instructions cause the processor to cause the system memory to receive the sound profiles from a source external to the system and cause the processor to receive a sound profile input from the controller. The sound profile input corresponds to a selected sound profile. The processor receives vehicle data from the output source of the vehicle, which corresponds to aspects of the current state of the vehicle. The processor compares the vehicle data to the selected sound profile to determine a sound output and cause the processor to cause the speakers to create a sound based on the sound output.

## Description

### BACKGROUND

The engines and exhaust systems of a vehicle makes a distinct sound while driving. The sound of each model of vehicle is different from another model of vehicle. In fact, some vehicle sounds have become recognizable by some vehicle enthusiasts such that they can identify a vehicle solely on hearing the engine and exhaust sounds.

Furthermore, modification of the sounds of a vehicle can be made by altering the exhaust and/or engine of the vehicle. This allows a vehicle owner to permanently or semi-permanently customize their vehicle's sound to distinguish it from other similar vehicles.

However, some vehicles produce an undesirable engine and/or exhaust sound or produce sounds that are too quiet. For example, electric vehicles do not have engines or exhaust systems, so electric vehicles do not produce these iconic sounds.

Thus, there is a need for a system to cause a vehicle to produce engine and/or exhaust sounds without permanently or semi-permanently modifying the sound of the vehicle.

### SUMMARY

Various implementations include a system for producing sounds of a vehicle. The system includes one or more speakers, a controller, a processor, and a system memory. The processor is in operative communication with an output source of a vehicle, the controller, and the one or more speakers. The processor executes computer-readable instructions stored on the system memory. The system memory is further configured to store two or more sound profiles. The instructions cause the processor to cause the system memory to receive the two or more sound profiles from a source external to the system. The instructions further cause the processor to receive a sound profile input from the controller. The sound profile input corresponds to a selected one of the two or more sound profiles. The instructions further cause the processor to receive vehicle data from the output source of the vehicle. The vehicle data corresponds to at least one aspect of the current state of the vehicle. The instructions further cause the processor to compare the vehicle data to the selected one of the two or more sound profiles to determine a sound output. The instructions further cause the processor to cause the one or more speakers to create a sound based on the sound output.

In some implementations, the output source of the vehicle includes a controller area network (CAN) bus.

In some implementations, the sound profile is a vehicle sound profile.

In some implementations, the instructions further cause the processor to determine a simulated gear and compare the vehicle data to the simulated gear in determining the sound output.

In some implementations, the system further includes an amplifier in electrical communication with the one or more speakers.

In some implementations, the one or more speakers includes two speakers. In some implementations, the sound created by the two speakers based on the sound output is in stereo. In some implementations, the stereo sound emulates the firing order of a V-engine.

In some implementations, the one or more speakers include a weatherproof enclosure. In some implementations, the one or more speakers are disposed externally on the vehicle.

In some implementations, the one or more speakers include a vibration isolator for decreasing at least some vibrations created by the one or more speakers to the vehicle. In some implementations, the vibration isolator is adjustable to selectively change an amount the vibrations are decreased to the vehicle.

In some implementations, the controller includes a display screen for displaying the one of the two or more sound profiles.

In some implementations, the source external to the system comprises a mobile device. In some implementations, the system further includes a Bluetooth receiver. In some implementations, the two or more sound profiles are communicated to the controller via the Bluetooth receiver. In some implementations, the system further includes a Wi-Fi receiver. In some implementations, the two or more sound profiles are communicated to the controller via the Wi-Fi receiver.

In some implementations, the instructions further cause the processor to determine whether a vehicle transmission is in a park position prior to causing the system memory to receive the two or more sound profiles from the source external to the system, and if the vehicle transmission is not in a park position, prevent the system memory from receiving the two or more sound profiles from the source external to the system.

In some implementations, the source external to the system allows a user to modify one or more of the two or more sound profiles prior to causing the system memory to receive the two or more sound profiles from a source external to the system. In some implementations, the source external to the system includes a source memory. In some implementations, the source external to the system allows a user to store the modified one or more of the two or more sound profiles on the source memory. In some implementations, the source external to the system includes a first source external to the system. In some implementations, the first source external to the system allows a user to share the modified one or more of the two or more sound profiles with a second source external to the system. In some implementations, the source external to the system displays modified sound profiles produced by other users and download the modified sound profiles produced by other users.

In some implementations, the source external to the system is configured to receive sound profiles from a server prior to the instructions causing the processor to cause the system memory to receive the sound profiles from the source external to the system.

In some implementations, the at least one aspect of the current state of the vehicle includes a throttle position. In some implementations, the at least one aspect of the current state of the vehicle includes a wheel rotational speed. In some implementations, the at least one aspect of the current state of the vehicle includes an engine load or a motor load.

In some implementations, the two or more sound profiles include one or more sounds from a specific existing vehicle.

Various other implementations include a system for producing sounds of a vehicle. The system includes one or more speakers, a vibration isolator, a processor, and a system memory. The vibration isolator is for decreasing at least some vibrations created by the one or more speakers to the vehicle. The processor is in operative communication with an output source of a vehicle and the one or more speakers. The processor executes computer-readable instructions stored on the system memory. The instructions causing the processor to receive vehicle data from the output source of the vehicle. The vehicle data corresponds to at least one aspect of the current state of the vehicle. The instructions further cause the processor to compare the vehicle data to a sound profile stored on the system memory to determine a sound output. The instructions further cause the processor to cause the one or more speakers to create a sound based on the sound output.

In some implementations, the output source of the vehicle includes a controller area network (CAN) bus.

In some implementations, the system memory stores one or more sound profiles. In some implementations, the sound profile is a selected one of the one or more sound profiles. In some implementations, the sound profile is a vehicle sound profile. In some implementations, the system further includes a controller for selecting the one of the one or more sound profiles. In some implementations, the processor is in operative communication with the controller. In some implementations, the instructions further cause the processor to receive a sound profile input from the controller. In some implementations, the sound profile input corresponds to the selected one of the one or more sound profiles.

In some implementations, the instructions further cause the processor to determine a simulated gear and compare the vehicle data to the simulated gear in determining the sound output..

In some implementations, the system further includes an amplifier in electrical communication with the one or more speakers.

In some implementations, the one or more speakers comprises two speakers. In some implementations, the sound created by the two speakers based on the sound output two speakers is in stereo. In some implementations, the stereo sound emulates the firing order of a V-engine.

In some implementations, the one or more speakers include a weatherproof enclosure. In some implementations, the one or more speakers are disposed externally on the vehicle.

In some implementations, the vibration isolator is adjustable to selectively change an amount the vibrations are decreased to the vehicle.

In some implementations, the controller includes a display screen for displaying the one of the one or more sound profiles. In some implementations, the instructions further cause the processor to cause the controller to receive the one or more sound profiles.

In some implementations, the controller includes a receiver for receiving the one or more sound profiles from a source external to the system. In some implementations, the source external to the system includes a mobile device. The system further includes a Bluetooth receiver. In some implementations, the one or more sound profiles are communicated to the controller via the Bluetooth receiver. In some implementations, the system further includes a Wi-Fi receiver. In some implementations, the one or more sound profiles are communicated to the controller via the Wi-Fi receiver.

In some implementations, the instructions further cause the processor to determine whether a vehicle transmission is in a park position prior to causing the system memory to receive the two or more sound profiles from the source external to the system, and if the vehicle transmission is not in a park position, prevent the system memory from receiving the two or more sound profiles from the source external to the system.

In some implementations, the source external to the system allows a user to modify one or more of the two or more sound profiles prior to causing the system memory to receive the two or more sound profiles from a source external to the system. In some implementations, the source external to the system includes a source memory. In some implementations, the source external to the system allows a user to store the modified one or more of the two or more sound profiles on the source memory. In some implementations, the source external to the system includes a first source external to the system. In some implementations, the first source external to the system allows a user to share the modified one or more of the two or more sound profiles with a second source external to the system. In some implementations, the source external to the system displays modified sound profiles produced by other users and download the modified sound profiles produced by other users.

In some implementations, the source external to the system is configured to receive sound profiles from a server prior to the instructions causing the processor to cause the system memory to receive the sound profiles from the source external to the system.

In some implementations, the at least one aspect of the current state of the vehicle includes a throttle position. In some implementations, the at least one aspect of the current state of the vehicle includes a wheel rotational speed. In some implementations, the at least one aspect of the current state of the vehicle includes an engine load or a motor load.

In some implementations, the one or more sound profiles include one or more sounds from a specific existing vehicle.

### BRIEF DESCRIPTION OF DRAWINGS

Example features and implementations of the present disclosure are disclosed in the accompanying drawings. However, the present disclosure is not limited to the precise arrangements and instrumentalities shown. Similar elements in different implementations are designated using the same reference numerals.
FIG. 1 is a diagram of a system for simulating or producing engine sounds, according to one implementation.
FIG. 2 is a diagrammatic view of a first set of instructions stored on the system memory of the system of FIG. 1.
FIG. 3 is a diagrammatic view of a second set of instructions stored on the system memory of the system of FIG. 1.
FIG. 4 is a diagrammatic view of a third set of instructions stored on the system memory of the system of FIG. 1.
FIG. 5 is an example computer system suitable for implementing the several embodiments of the disclosure.
FIG. 6 is a front view of the interface of the controller of the system of FIG. 1.
FIG. 7 is a perspective view of the speakers of the system of FIG. 1.
FIG. 8 is a detailed perspective view of the vibration isolator of the speakers of FIG. 7.

### DETAILED DESCRIPTION

The devices, systems, and methods disclosed herein provide for a system for simulating or producing engine sounds, exhaust sounds, and/or any other sounds in a vehicle. The system allows a user to download onto a mobile device or other source one or more sound profiles for specific vehicle engine and/or exhaust sounds, modified vehicle engine and/or exhaust sounds, or sounds that are unrelated to vehicles. The user can then modify the sound profiles and even share the modified sound profiles with other users through an application.

The user can then transfer one or more sound profiles to a controller that is mounted within a vehicle. The controller stores each sound profile to a preset position selectable on the controller interface. The controller uses vehicle dynamics and/or other information received from the vehicle (e.g., through the vehicle CAN bus) to determine a sound output based on the selected sound profile. As the vehicle dynamics and/or other information received from the vehicle change (e.g., the transmission shifts, the accelerator pedal position changes, the vehicle speed changes), the controller changes the output based on the sound profile to make the sound output dynamic and track the vehicle being driven.

The system then sends the sound output signal to an amplifier and then to speakers mounted external to the vehicle cabin to simulate or produce the vehicle engine sounds, exhaust sounds, and/or any other sounds corresponding to the sound profile vehicle. The speakers are mounted with one or more vibration isolators that can be adjusted or selected to transfer a desired amount of vibrations from the speakers to the driver inside of the vehicle. These vibrations can simulate the vibrations associated with the sound profile vehicle.

This system can allow a user with a vehicle that produces undesirable engine and/or exhaust sounds or produces sounds that are too quiet to enjoy a vehicle that produces any desired engine sounds, exhaust sounds, and/or any other sounds. This system is especially suited for electric or hybrid vehicles that do not have or sometimes do not use engines or exhaust systems. A user of an electric or hybrid vehicle that includes a system as described herein can simulate any internal combustion engine vehicle, or produce sounds of any other type of real or fictitious vehicle or device, with the press of a button.

Various implementations include a system for producing sounds of a vehicle. The system includes one or more speakers, a controller, a processor, and a system memory. The processor is in operative communication with an output source of a vehicle, the controller, and the one or more speakers. The processor executes computer-readable instructions stored on the system memory. The system memory is further configured to store two or more sound profiles. The instructions cause the processor to cause the system memory to receive the two or more sound profiles from a source external to the system. The instructions further cause the processor to receive a sound profile input from the controller. The sound profile input corresponds to a selected one of the two or more sound profiles. The instructions further cause the processor to receive vehicle data from the output source of the vehicle. The vehicle data corresponds to at least one aspect of the current state of the vehicle. The instructions further cause the processor to compare the vehicle data to the selected one of the two or more sound profiles to determine a sound output. The instructions further cause the processor to cause the one or more speakers to create a sound based on the sound output.

Various other implementations include a system for producing sounds of a vehicle. The system includes one or more speakers, a vibration isolator, a processor, and a system memory. The vibration isolator is for decreasing at least some vibrations created by the one or more speakers to the vehicle. The processor is in operative communication with an output source of a vehicle and the one or more speakers. The processor executes computer-readable instructions stored on the system memory. The instructions causing the processor to receive vehicle data from the output source of the vehicle. The vehicle data corresponds to at least one aspect of the current state of the vehicle. The instructions further cause the processor to compare the vehicle data to a sound profile stored on the system memory to determine a sound output. The instructions further cause the processor to cause the one or more speakers to create a sound based on the sound output.

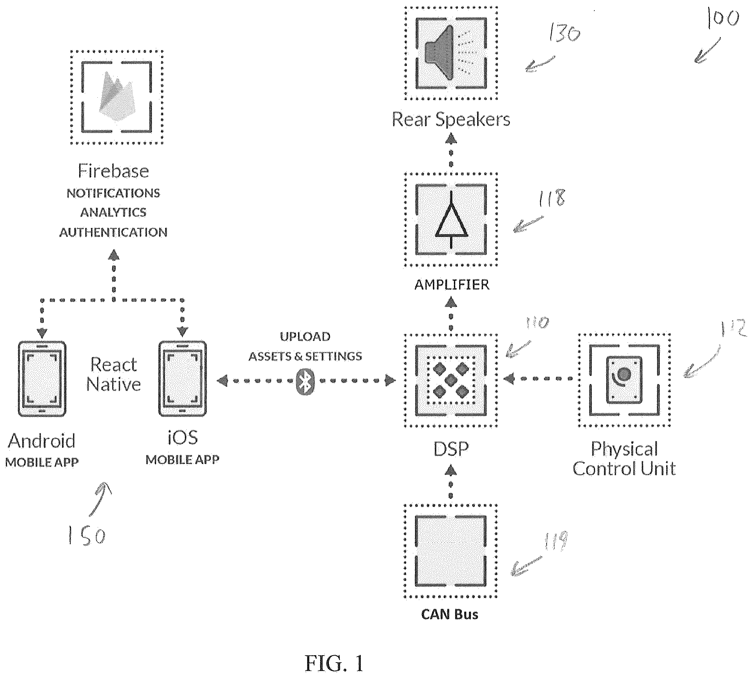

FIG. 1 shows a diagram of a system 100 for simulating or producing sounds of an engine or any other device that includes aspects of various implementations. The system 100 includes a controller 110, a digital signal processor (DSP) 118, an amplifier 118, and one or more speakers 130.

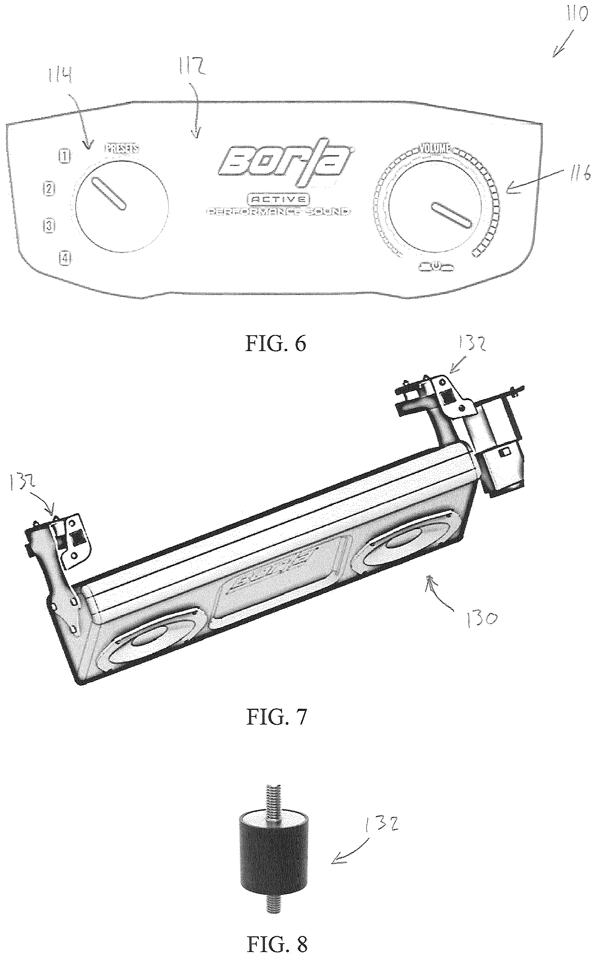

FIG. 6 shows the interface 112 of the controller 110 of the system 100 of FIG. 1. The controller 110 is configured to be coupled to a portion of the interior of a vehicle in a location that is accessible by the driver of the vehicle. In some implementations, the controller may be coupled to the dashboard, a center console, or steering column of the vehicle.

The interface 112 includes a presets dial 114 and a volume/power dial 116. The volume/power dial 116 can be rotated to adjust the volume of sound transmitted and can be depressed to toggle the power to the controller 110 between an "On" and an "Off' configuration. In some implementations, the volume dial may include other actions upon depression, such as muting the volume.

The presets dial 114 includes four rotational hard stop preset positions. Each preset position of the preset dial 114 activates one of the four sound profiles being stored on the system memory, as discussed below. The sound profiles can be vehicle sound profiles or sound profiles of anything else. Although the controller 110 shown in FIG. 6 only includes information such as preset positions and volume on the interface 112, in some implementations, the controller can include a display for displaying information related to the system.

The processor and the system memory are physically located within the controller 110. The processor produces sound output signals based on executing computer-readable instructions stored on the system memory, inputs from the controller interface, and inputs from the vehicle.

The processor is in operative communication with an output source of a vehicle, the controller 110, and the one or more speakers 130. The output source of the vehicle can be the controller area network (CAN) bus 119. The CAN bus 119 of a vehicle is configured to output one or more aspects of the current state of the vehicle, also called vehicle dynamics. Examples of vehicle dynamics include, but are not limited to, a throttle position, a wheel rotational speed, an engine load, a motor load, an accelerator pedal position, measured acceleration (e.g., by accelerometer), piston firing order, altitude change, a gear selector position, a key position, a speedometer output, or a rotation per minute (RPM) output. In some implementations, the system may include one or more sensors configured to measure one or more aspect of the current state of the vehicle and function as the output source of the vehicle, either in addition to the CAN bus 119 or instead of the CAN bus 119.

FIGS. 1-4 show example diagrams of various computer-readable instructions stored on the system memory and executed by the processor. The instructions first cause the processor to receive a sound profile input from the interface 112 or the controller 110. The sound profile input corresponds to a selected one of the four sound profiles stored on the system memory. A user can select the sound profile input by rotating the presets dial 114 on the interface 112 of the controller 110 to a hard stop position corresponding to the desired sound profile. The controller 110 then provides the selected sound profile input to the processor.

The instructions then cause the processor to receive vehicle data corresponding to at least one aspect of the current state of the vehicle from one or more output sources of the vehicle, such as the CAN bus 119 or sensors.

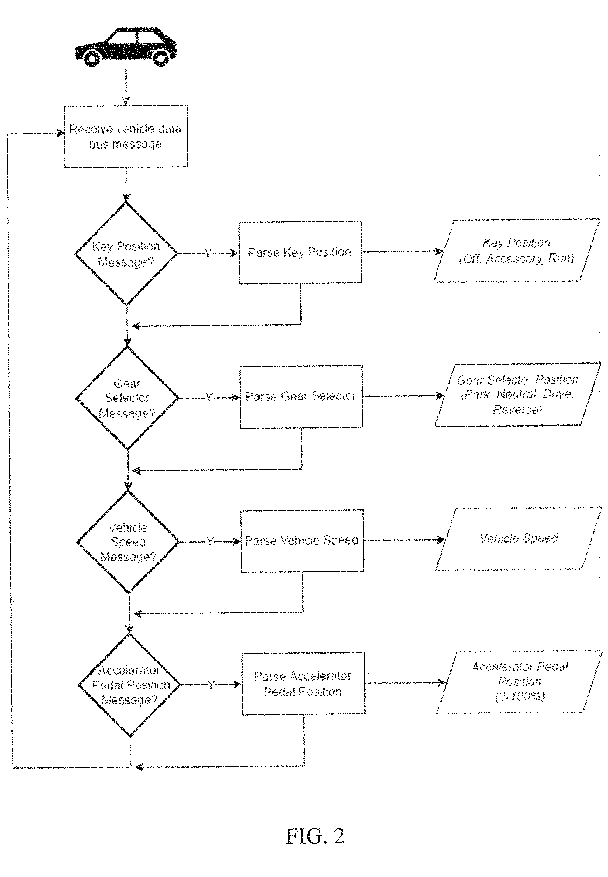

Next, the instructions cause the processor to parse the incoming vehicle data message from the CAN bus 119. FIG. 2 shows an example diagram of the processor receiving the vehicle data from the CAN bus 119 and parsing the data. After receiving the vehicle data CAN bus 119 message, the processor parses the key position message to determine whether the key is in the "Off," "Accessory," or "Run" position. Next, the processor parses the gear selector position message to determine whether the gear selector is in the "Park," "Neutral," "Drive," or "Reverse" position. The processor then parses the vehicle speed message to determine the velocity of the vehicle. Then, the processor parses the accelerator pedal position message to determine the position that the accelerator pedal has been depressed as a percentage of depression.

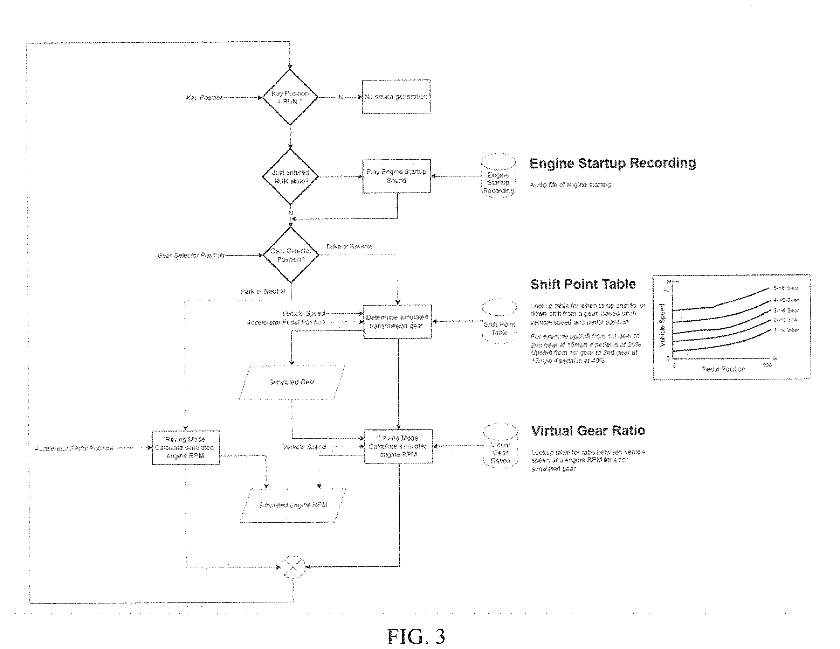

FIG. 3 shows an example diagram of how the instructions cause the processor to determine a sound output. First, the instructions cause the processor to determine whether the vehicle engine or motor is running. The processor is caused to compare the parsed key position to determine whether the key is in the "Run" position. If the key is not in the "Run" position, then the engine or motor has not been started and, therefore, a sound output should not be output.

If the key is in the "Run" position, then the processor proceeds to determine if the vehicle just entered the "Run" position. The processor compares the key position to the previous key position to determine whether the vehicle was previously in a position other than the "Run" position. If the previous key position was in a position other than the "Run" position, then the instructions cause the processor to output a startup recording output associated with the currently selected sound profile. The startup recording output is a signal that is configured to cause the speakers of the system to output a sound associated with the startup for the simulated vehicle corresponding to the selected sound profile.

If the vehicle was previously in the "Run" position, the instructions cause the processor to determine whether the vehicle should be in "Revving Mode" or a "Driving Mode." The processor reviews the gear selector position to determine whether the vehicle is in the "Park" or "Neutral" positions. If the vehicle is in the "Park" or "Neutral" position, then the processor determines that the vehicle should be in the "Revving Mode." In "Revving Mode," the instructions cause the processor to determine the simulated engine rotations per minute (RPM) based on the current accelerator pedal position.

If the processor determines that the gear selector position of the vehicle is in the "Drive" or "Reverse" position, then the processor determines that the vehicle is in a "Driving Mode." In "Driving Mode," the instructions cause the processor to determine when to simulate transmission gear based on a shift point table. The shift point table includes a plurality of gear shifting thresholds as functions of the vehicle speed and accelerator pedal position. The instructions then cause the processor to determine the simulated engine RPM based on the simulated gear and the vehicle speed.

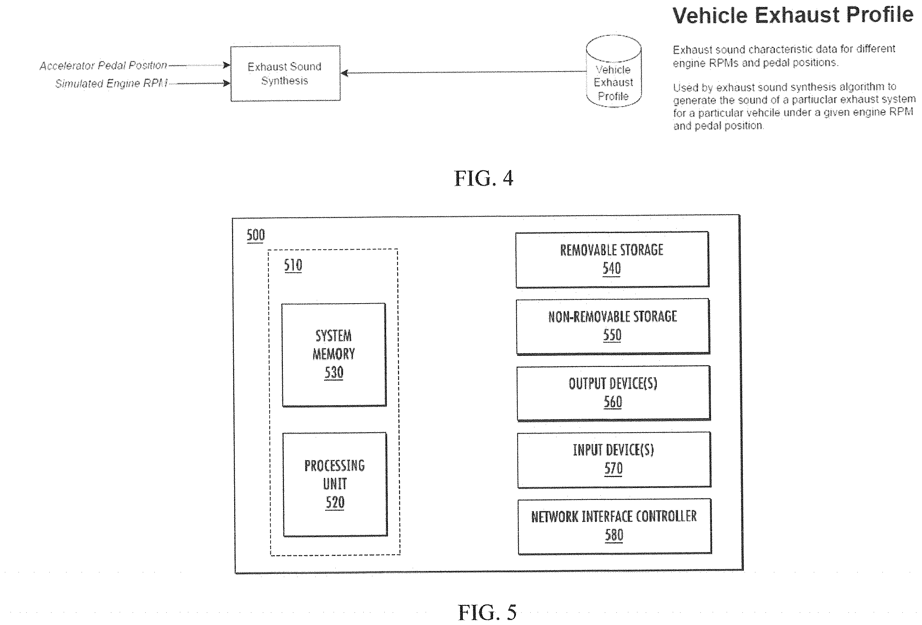

As shown in FIG. 4, the instructions use the information from above to determine a sound output. The processor accesses the selected sound profile and uses an exhaust sound synthesis algorithm to generate a sound output mimicking or producing the exhaust sounds or other sounds of the selected sound profile based on the determined accelerator pedal position and simulated engine RPM.

FIG. 7 shows an example of the speakers 130 of the system 100. Once a sound output is determined, the instructions cause the processor to send the sound output signal to the amplifier 118 and then the amplified sound output signal to the speakers 130 to cause the speakers 130 to generate a sound based on the sound output. The speakers 130 can also include an amplifier that is included in the speaker 130 (FIG. 7) or an external amplifier.

The speakers 130 are configured to be mounted to a vehicle externally to the cabin of the vehicle. In some implementations, the speakers can be mounted such that the speakers are external to the engine compartment. Because the speakers 130 are mounted externally to the cabin of the vehicle, the speakers 130 can include a weatherproof enclosure to protect the speakers 130 from the elements. In some implementations, the speakers can further include speakers mounted internally to the cabin of the vehicle. The internal speakers can include factory installed speakers and/or speakers in addition to the factory installed speakers.

The speakers 130 are mounted using vibration isolators 132 for decreasing the amount of vibrations created by the speakers 130 that are transferred to the vehicle. The vibrations from the speakers 130 being transferred to the vehicle are configured to mimic the vibrations of an engine and/or exhaust system.

The vibration isolators 132 are shown in detail in FIG. 8. The vibration isolators 132 can be adjustable vibration isolators 132 for selectively changing the amount of vibrations transferred from the speakers 130 to the vehicle. A user can manually adjust the vibration isolators 132 to more accurately mimic the amount of vibration an engine and/or exhaust system of a given simulated vehicle would transfer to the driver of the vehicle. In some implementations, the vibration dampers are automatically adjustable by the controller based on input from the user, information stored on the system memory, or both. In some implementations, the vibration isolators are replaceable with harder or softer vibration isolators to selectively change an amount the vibrations and/or sounds are decreased or increased to the vehicle.

FIG. 7 shows two speakers 130 that are configured to output sound in stereo. Some sound profiles may be configured to provide a sound output in stereo that mimics the firing order of a V-engine. However, in some implementations, the system only includes one speaker. In some implementations, the system includes three or more speakers.

The controller 110 shown in FIG. 6 is preloaded with sound profiles stored for each preset position. However, the controller 110 is capable of receiving one or more sound profiles from a source 150 external to the system 100 and storing those sound profiles in the system memory in a preset position. The controller 110 shown in FIG. 6 includes a Bluetooth receiver in operative communication with the processor. A signal can be received by the Bluetooth receiver that can be stored by the processor in the system memory as a sound profile. The Bluetooth signal can also include information regarding in which preset position a user would like the received sound profile stored.

Although the controller 110 shown in FIG. 6 includes a Bluetooth receiver for receiving from a source 150 external to the system 100 a signal corresponding to a sound profile, in some implementations, the controller can include a Wi-Fi receiver, a direct input port, or any other means for receiving a signal.

The source 150 external to the system 100 shown in FIG. 1 is a mobile device, however in some implementations, the source can be any mobile device, a mobile phone, a computer, or any device capable of sending a signal corresponding to a sound profile to the controller. The mobile device 150 can include software that allows a user to select a desired sound profile and send the sound profile information to the controller 110 to be stored in the system memory. As discussed above, the signal sent by the mobile device 150 can further include a preset position into which the sound profile is to be stored. This preset position can be user selected or can be automatic.

The application of the mobile device 150 can further allow a user to download new sound profiles to the mobile device 150, for example, from a server. The application can display a list of names and descriptions for sound profiles that a user can review. The names and descriptions can correspond to stock vehicles, modified vehicles, fictitious sounds, or any other sound. The user can then select a desired sound profile to sample the sound profile. If the user wants to download the sound profile, the user can cause the mobile device 150 to download the desired sound profile to the mobile device 150. Once the user has downloaded the desired sound profile, the user can then cause the mobile device 150to send a signal corresponding to the sound profile to the controller 110 to be stored in the system memory.

The controller 110 can also include instructions for preventing a signal from being received by the Bluetooth receiver when the vehicle is being driven. This can prevent a user from sending new sound profiles to the system 100 while driving, which can be a safety concern. The instructions stored on the system memory cause the processor to determine whether a vehicle transmission is in the "Park" position or if the vehicle transmission is in the "Neutral," Reverse," or "Drive" positions. If the processor determines that the vehicle transmission is not in the "Park" position, the instructions cause the processor to prevent the system memory from receiving sound profiles from the mobile device 150 or other source 150 external to the system 100.

The use of an application on a mobile device 150 or other source 150 external to the system 100 is beneficial because many vehicles do not have standalone internet capabilities or require a user to pay extra for internet services. However, most users will have at least one device 150 external to the system 100 that has access to the internet for downloading sound profiles and the ability to transmit signals corresponding to the sound profiles to the system 100. Thus, the use of the source 150 external to the system 100 prevents the need for a vehicle or the system 100 itself to have internet capabilities. Furthermore, the use of the device 150 external to the system 100 allows for the user to view the sound profiles on the device's 150 screen before causing the sound profile to be stored to a preset position of the controller 110. In this way, the interface 112 of the controller 110 does not need to indicate the sound profile stored to a particular preset position. Instead, this information can be viewed on the device 150 external to the system 100. The use of the source 150 external to the system 100 also allows for other benefits that are discussed below.

The application of the mobile device 150 can further allow a user to modify or customize a sound profile stored on the source memory of the mobile device 150. When a sound profile is stored on the mobile device 150 (either preloaded or downloaded onto the device 150), the user has the option to modify one or more features of the sound profile. These features can include, but are not limited to, the shift point table thresholds for simulated gear shifting, the pitch or tone of certain sounds in the sound profile, the balance of the sound for the stereo speakers, or the timing of the sounds. The modified sound profile can then be stored on the mobile device 150 and can be caused to be transmitted and stored on the system memory.

The application can also allow a user to establish a user profile and permit other users to access certain information on the user profile. For example, a user can allow other users to access their library of predetermined sound profiles and modified profiles that are listed on their user profile. The other user can review the listed sound profiles on the user profile and can sample the sound profiles. The other user can then download or request to download certain sound profiles from the user profile. This enables users to create new sound profiles that they can then share with other users on the application. The application also allows a user to message another user, which can allow users to collaborate on customized sound profiles through the application.

It should be appreciated that the logical operations described herein with respect to the various figures may be implemented (1) as a sequence of computer implemented acts or program modules (i.e., software) running on a computing device (e.g., the computing device described in FIG. 5), (2) as interconnected machine logic circuits or circuit modules (i.e., hardware) within the computing device and/or (3) a combination of software and hardware of the computing device. Thus, the logical operations discussed herein are not limited to any specific combination of hardware and software. The implementation is a matter of choice dependent on the performance and other requirements of the computing device. Accordingly, the logical operations described herein are referred to variously as operations, structural devices, acts, or modules. These operations, structural devices, acts and modules may be implemented in software, in firmware, in special purpose digital logic, and any combination thereof. It should also be appreciated that more or fewer operations may be performed than shown in the figures and described herein. These operations may also be performed in a different order than those described herein.

Referring to FIG. 5, an example computing device 500 upon which embodiments of the invention may be implemented is illustrated. For example, the controller system described herein may each be implemented as a computing device, such as computing device 500. It should be understood that the example computing device 500 is only one example of a suitable computing environment upon which embodiments of the invention may be implemented. Optionally, the computing device 500 can be a well-known computing system including, but not limited to, personal computers, servers, handheld or laptop devices, multiprocessor systems, microprocessor-based systems, network personal computers (PCs), minicomputers, mainframe computers, embedded systems, and/or distributed computing environments including a plurality of any of the above systems or devices. Distributed computing environments enable remote computing devices, which are connected to a communication network or other data transmission medium, to perform various tasks. In the distributed computing environment, the program modules, applications, and other data may be stored on local and/or remote computer storage media.

In an embodiment, the computing device 500 may comprise two or more computers in communication with each other that collaborate to perform a task. For example, but not by way of limitation, an application may be partitioned in such a way as to permit concurrent and/or parallel processing of the instructions of the application. Alternatively, the data processed by the application may be partitioned in such a way as to permit concurrent and/or parallel processing of different portions of a data set by the two or more computers. In an embodiment, virtualization software may be employed by the computing device 500 to provide the functionality of a number of servers that is not directly bound to the number of computers in the computing device 500. For example, virtualization software may provide twenty virtual servers on four physical computers. In an embodiment, the functionality disclosed above may be provided by executing the application and/or applications in a cloud computing environment. Cloud computing may comprise providing computing services via a network connection using dynamically scalable computing resources. Cloud computing may be supported, at least in part, by virtualization software. A cloud computing environment may be established by an enterprise and/or may be hired on an as-needed basis from a third party provider. Some cloud computing environments may comprise cloud computing resources owned and operated by the enterprise as well as cloud computing resources hired and/or leased from a third party provider.

In its most basic configuration, computing device 500 typically includes at least one processing unit 520 and system memory 530. Depending on the exact configuration and type of computing device, system memory 530 may be volatile (such as random access memory (RAM)), non-volatile (such as read-only memory (ROM), flash memory, etc.), or some combination of the two. This most basic configuration is illustrated in FIG. 5 by dashed line 510. The processing unit 520 may be a standard programmable processor that performs arithmetic and logic operations necessary for operation of the computing device 500. While only one processing unit 520 is shown, multiple processors may be present. Thus, while instructions may be discussed as executed by a processor, the instructions may be executed simultaneously, serially, or otherwise executed by one or multiple processors. The computing device 500 may also include a bus or other communication mechanism for communicating information among various components of the computing device 500.

Computing device 500 may have additional features/functionality. For example, computing device 500 may include additional storage such as removable storage 540 and non-removable storage 550 including, but not limited to, magnetic or optical disks or tapes. Computing device 500 may also contain network connection(s) 580 that allow the device to communicate with other devices such as over the communication pathways described herein. The network connection(s) 580 may take the form of modems, modem banks, Ethernet cards, universal serial bus (USB) interface cards, serial interfaces, token ring cards, fiber distributed data interface (FDDI) cards, wireless local area network (WLAN) cards, radio transceiver cards such as code division multiple access (CDMA), global system for mobile communications (GSM), long-term evolution (LTE), worldwide interoperability for microwave access (WiMAX), and/or other air interface protocol radio transceiver cards, and other well-known network devices. Computing device 500 may also have input device(s) 570 such as a keyboards, keypads, switches, dials, mice, track balls, touch screens, voice recognizers, card readers, paper tape readers, or other well-known input devices. Output device(s) 560 such as a printers, video monitors, liquid crystal displays (LCDs), touch screen displays, displays, speakers, etc. may also be included. The additional devices may be connected to the bus in order to facilitate communication of data among the components of the computing device 500. All these devices are well known in the art and need not be discussed at length here.

The processing unit 520 may be configured to execute program code encoded in tangible, computer-readable media. Tangible, computer-readable media refers to any media that is capable of providing data that causes the computing device 500 (i.e., a machine) to operate in a particular fashion. Various computer-readable media may be utilized to provide instructions to the processing unit 520 for execution. Example tangible, computer-readable media may include, but is not limited to, volatile media, non-volatile media, removable media and non-removable media implemented in any method or technology for storage of information such as computer readable instructions, data structures, program modules or other data. System memory 530, removable storage 540, and non-removable storage 550 are all examples of tangible, computer storage media. Example tangible, computer-readable recording media include, but are not limited to, an integrated circuit (e.g., field-programmable gate array or application-specific IC), a hard disk, an optical disk, a magneto-optical disk, a floppy disk, a magnetic tape, a holographic storage medium, a solid-state device, RAM, ROM, electrically erasable program read-only memory (EEPROM), flash memory or other memory technology, CD-ROM, digital versatile disks (DVD) or other optical storage, magnetic cassettes, magnetic tape, magnetic disk storage or other magnetic storage devices.

It is fundamental to the electrical engineering and software engineering arts that functionality that can be implemented by loading executable software into a computer can be converted to a hardware implementation by well-known design rules. Decisions between implementing a concept in software versus hardware typically hinge on considerations of stability of the design and numbers of units to be produced rather than any issues involved in translating from the software domain to the hardware domain. Generally, a design that is still subject to frequent change may be preferred to be implemented in software, because re-spinning a hardware implementation is more expensive than re-spinning a software design. Generally, a design that is stable that will be produced in large volume may be preferred to be implemented in hardware, for example in an application specific integrated circuit (ASIC), because for large production runs the hardware implementation may be less expensive than the software implementation. Often a design may be developed and tested in a software form and later transformed, by well-known design rules, to an equivalent hardware implementation in an application specific integrated circuit that hardwires the instructions of the software. In the same manner as a machine controlled by a new ASIC is a particular machine or apparatus, likewise a computer that has been programmed and/or loaded with executable instructions may be viewed as a particular machine or apparatus.

In an example implementation, the processing unit 520 may execute program code stored in the system memory 530. For example, the bus may carry data to the system memory 530, from which the processing unit 520 receives and executes instructions. The data received by the system memory 530 may optionally be stored on the removable storage 540 or the non-removable storage 550 before or after execution by the processing unit 520.

It should be understood that the various techniques described herein may be implemented in connection with hardware or software or, where appropriate, with a combination thereof. Thus, the methods and apparatuses of the presently disclosed subject matter, or certain aspects or portions thereof, may take the form of program code (i.e., instructions) embodied in tangible media, such as floppy diskettes, CD-ROMs, hard drives, or any other machine-readable storage medium wherein, when the program code is loaded into and executed by a machine, such as a computing device, the machine becomes an apparatus for practicing the presently disclosed subject matter. In the case of program code execution on programmable computers, the computing device generally includes a processor, a storage medium readable by the processor (including volatile and non-volatile memory and/or storage elements), at least one input device, and at least one output device. One or more programs may implement or utilize the processes described in connection with the presently disclosed subject matter, e.g., through the use of an application programming interface (API), reusable controls, or the like. Such programs may be implemented in a high level procedural or object-oriented programming language to communicate with a computer system. However, the program(s) can be implemented in assembly or machine language, if desired. In any case, the language may be a compiled or interpreted language and it may be combined with hardware implementations.

Embodiments of the methods and systems may be described herein with reference to block diagrams and flowchart illustrations of methods, systems, apparatuses and computer program products. It will be understood that each block of the block diagrams and flowchart illustrations, and combinations of blocks in the block diagrams and flowchart illustrations, respectively, can be implemented by computer program instructions. These computer program instructions may be loaded onto a general purpose computer, special purpose computer, or other programmable data processing apparatus to produce a machine, such that the instructions which execute on the computer or other programmable data processing apparatus create a means for implementing the functions specified in the flowchart block or blocks.

These computer program instructions may also be stored in a computer-readable memory that can direct a computer or other programmable data processing apparatus to function in a particular manner, such that the instructions stored in the computer-readable memory produce an article of manufacture including computer-readable instructions for implementing the function specified in the flowchart block or blocks. The computer program instructions may also be loaded onto a computer or other programmable data processing apparatus to cause a series of operational steps to be performed on the computer or other programmable apparatus to produce a computer-implemented process such that the instructions that execute on the computer or other programmable apparatus provide steps for implementing the functions specified in the flowchart block or blocks.

Accordingly, blocks of the block diagrams and flowchart illustrations support combinations of means for performing the specified functions, combinations of steps for performing the specified functions and program instruction means for performing the specified functions. It will also be understood that each block of the block diagrams and flowchart illustrations, and combinations of blocks in the block diagrams and flowchart illustrations, can be implemented by special purpose hardware-based computer systems that perform the specified functions or steps, or combinations of special purpose hardware and computer instructions.

A number of example implementations are provided herein. However, it is understood that various modifications can be made without departing from the spirit and scope of the disclosure herein. As used in the specification, and in the appended claims, the singular forms "a," "an," "the" include plural referents unless the context clearly dictates otherwise. The term "comprising" and variations thereof as used herein is used synonymously with the term "including" and variations thereof and are open, non-limiting terms. Although the terms "comprising" and "including" have been used herein to describe various implementations, the terms "consisting essentially of" and "consisting of" can be used in place of "comprising" and "including" to provide for more specific implementations and are also disclosed.

Disclosed are materials, systems, devices, methods, compositions, and components that can be used for, can be used in conjunction with, can be used in preparation for, or are products of the disclosed methods, systems, and devices. These and other components are disclosed herein, and it is understood that when combinations, subsets, interactions, groups, etc. of these components are disclosed that while specific reference of each various individual and collective combinations and permutations of these components may not be explicitly disclosed, each is specifically contemplated and described herein. For example, if a device is disclosed and discussed each and every combination and permutation of the device are disclosed herein, and the modifications that are possible are specifically contemplated unless specifically indicated to the contrary. Likewise, any subset or combination of these is also specifically contemplated and disclosed. This concept applies to all aspects of this disclosure including, but not limited to, steps in methods using the disclosed systems or devices. Thus, if there are a variety of additional steps that can be performed, it is understood that each of these additional steps can be performed with any specific method steps or combination of method steps of the disclosed methods, and that each such combination or subset of combinations is specifically contemplated and should be considered disclosed.

## Claims

1. A system for simulating engine sounds, the system comprising:
one or more speakers;
a controller; and
a processor and a system memory, the processor being in operative communication with an output source of a vehicle, the controller, and the one or more speakers, wherein the processor executes computer-readable instructions stored on the system memory, the system memory being further configured to store two or more sound profiles, the instructions causing the processor to:
cause the system memory to receive the two or more sound profiles from a source external to the system,
receive a sound profile input from the controller, wherein the sound profile input corresponds to a selected one of the two or more sound profiles,
receive vehicle data from the output source of the vehicle, wherein the vehicle data corresponds to at least one aspect of the current state of the vehicle,
compare the vehicle data to the selected one of the two or more sound profiles to determine a sound output, and
cause the one or more speakers to create a sound based on the sound output.

2. The system of claim 1, wherein the sound profile is a vehicle sound profile from a specific existing vehicle.

3. The system of claim 1, wherein the instructions further cause the processor to:
determine a simulated gear; and
compare the vehicle data to the simulated gear in determining the sound output.

4. The system of claim 1, further comprising an amplifier in electrical communication with the one or more speakers.

5. The system of claim 1, wherein the one or more speakers comprises two speakers, wherein the sound created by the two speakers based on the sound output is in stereo.

6. The system of claim 5, wherein the stereo sound emulates the firing order of a V-engine.

7. The system of claim 1, wherein the one or more speakers are disposed externally on the vehicle, wherein the one or more speakers include a weatherproof enclosure.

8. The system of claim 1, wherein the one or more speakers include a vibration isolator for decreasing at least some vibrations created by the one or more speakers to the vehicle, preferably wherein the vibration isolator is adjustable to selectively change an amount the vibrations are decreased to the vehicle.

9. The system of claim 1, wherein the controller includes a display screen for displaying the one of the two or more sound profiles.

10. The system of claim 1, wherein the source external to the system comprises a mobile device.

11. The system of claim 1, further comprising a Bluetooth receiver or a Wi-Fi receiver, wherein the two or more sound profiles are communicated to the controller via the Bluetooth receiver or Wi-Fi receiver, respectively.

12. The system of claim 1, wherein the instructions further cause the processor to:
determine whether a vehicle transmission is in a park position prior to causing the system memory to receive the two or more sound profiles from the source external to the system, and
if the vehicle transmission is not in a park position, prevent the system memory from receiving the two or more sound profiles from the source external to the system.

13. The system of claim 1, wherein the source external to the system allows a user to modify one or more of the two or more sound profiles prior to causing the system memory to receive the two or more sound profiles from a source external to the system.

14. The system of claim 1, wherein the source external to the system is configured to receive sound profiles from a server prior to the instructions causing the processor to cause the system memory to receive the sound profiles from the source external to the system.

15. The system of claim 1, wherein the at least one aspect of the current state of the vehicle comprises a throttle position, a wheel rotational speed, an engine load, or a motor load.
